# EUROPEAN PATENT APPLICATION

(11) **EP 2 856 900 A1**
(43) Date of publication of application: **08.04.2015**
(21) Application number: 13819501.1
(22) Date of filing: 22.05.2013
(51) Int. Cl.: A44B 13/00, A44B 1/38, A44C 25/00

(54) **MULTIFUNCTIONAL ACCESSORY FOR PORTABLE DEVICE**

(30) Priority: 16.07.2012 KR 20120077080; 14.11.2012 KR 20120128513
(71) Applicant: Noh, Seonsu, Busan 609-750 (KR)
(72) Inventor: Noh, Seonsu, Busan 609-750 (KR)
(74) Representative: Gulde & Partner
(86) International application number: PCT/KR2013/004487
(87) International publication number: WO 2014/014194

(57) **Abstract**

The present invention relates to a multifunctional accessory for a portable device. According to embodiment of the present invention for providing a multifunctional accessory for a portable device having a simple configuration and can be variously applied, the multifunctional accessory comprises: a main body comprising a coupling means to be attached to or detached from a portable device; a rotation bracket provided at the center of another lateral side of the main body to revolve along the circumference direction and comprising a mounting hole formed by penetrating a part of the lateral side thereof; a rectangular rotation ring rotatably mounted on the mounting hole of the rotation bracket and comprising a bent protrusion formed by bending at least a part of a free end opposite to the mounting hole in any one direction; and a resilient member provided at the mounting hole and resiliently supporting at least a part of the circumference of the rotation ring. According to the present invention, the multifunctional accessory can be applied to various uses such as a stand, a belt hanger, a finger holder and the like by a simple configuration and an easy operation.

## Description

### TECHNICAL FIELD

The present invention relates to a multifunctional accessory for portable device, and more particularly, a multifunctional accessory for portable device which can be applied as a holder or a stand etc..

### BACKGROUND ART

In recent, propagation of various portable multimedia devices such as smart phones or tablet PCs etc. explosively increases and they are used for various uses. With such a propagation of the portable device, accessory auxiliarily mounted on the portable device is also variously launched and is used for various uses. Typical accessory for portable device includes a cellular phone ring used by fastening traffic car or touch pen thereto, a stand for standing the portable device on flat place or inclined surface in order to use multimedia functions, a finger holder which is fastened to a finger or bag for preventing the loss of portable device.

However, the above-described accessories are almost limited to only one use, and thus, for being used for another use, require additional purchase of another accessory and have to be used together with the existing accessory or alternately therewith, which is cumbersome.

### SUMMARY OF THE INVENTION

### Technical problem

The present invention was made to solve the above-mentioned problems, and its object is to provide a multifunctional accessory for portable device which can be applied for various uses with a simple configuration.

### Solution to the problem

The above-mentioned object is achieved by a multifunctional accessory for portable device which is detachably attached to the portable device, comprising: a main body provided with coupling means which is detachably attached to the portable device; a rotatable bracket which is provided on a central portion of the other lateral surface of the main body and revolves along a circumferential direction and which has a mounting hole formed by penetrating a part of lateral surface of the bracket; a rotatable ring which has a shape of rectangular ring and is rotatably mounted in the mounting hole of the rotatable bracket and which has a bent protrusion formed by bending at least a part of free end of the ring facing the mounting hole in one direction; and an elastic member which is provided in the mounting hole and elastically supports at least a part of circumferential surface of the rotatable ring, wherein cross section of the mounting hole formed in the rotatable bracket has a polygonal shape with at least four sides, cross section of the rotatable ring is formed to correspond to the polygonal shape of the mounting hole, and thus the rotatable ring has a predetermined rotational angle.

Herein, the coupling means may consist of adhesive rubber pad. Furthermore, a frictional member made of rubber material may be fixed to an end portion of the bent protrusion of the rotatable ring.

Meanwhile, according to another embodiment of the present invention, the above-mentioned object is achieved by a multifunctional accessory for portable device which is detachably attached to the portable device, comprising: a protective case which is formed to wrap side and rear surfaces of the portable device and which has an opening part of predetermined shape on one side of the case; a main body provided with coupling means which comprises a coupling groove member inserted in the inside of the opening part of the protective case and a coupling protrusion detachably coupled with the coupling groove member; a rotatable bracket which is provided on a central portion of the other lateral surface of the main body and revolves along a circumferential direction and which has a mounting hole formed by penetrating a part of lateral surface of the bracket; a rotatable ring which has a shape of rectangular ring and is rotatably mounted in the mounting hole of the rotatable bracket and which has a bent protrusion formed by bending at least a part of free end of the ring facing the mounting hole in one direction; and an elastic member which is provided in the mounting hole and elastically supports at least a part of circumferential surface of the rotatable ring.

Furthermore, according to another embodiment of the present invention, the above-mentioned object is achieved by a multifunctional accessory for portable device which is detachably attached to the portable device, comprising: a piercing member which pierces one side of a rear cover of the portable device to form an opening part of predetermined shape; a main body provided with coupling means which comprises a coupling groove member inserted in the inside of the opening part of the cover and a coupling protrusion detachably coupled with the coupling groove member; a rotatable bracket which is provided on a central portion of the other lateral surface of the main body and revolves along a circumferential direction and which has a mounting hole formed by penetrating a part of lateral surface of the bracket; a rotatable ring which has a shape of rectangular ring and is rotatably mounted in the mounting hole of the rotatable bracket and which has a bent protrusion formed by bending at least a part of free end of the ring facing the mounting hole in one direction; and an elastic member which is provided in the mounting hole and elastically supports at least a part of circumferential surface of the rotatable ring.

Furthermore, according to yet another embodiment of the present invention, the above-mentioned object is achieved by s multifunctional accessory for portable device which is detachably attached to the portable device, comprising: a main body provided with coupling means which is detachably attached to the portable device; a rotatable bracket which is provided on a central portion of the other lateral surface of the main body and revolves along a circumferential direction and which has a mounting hole formed by penetrating a part of lateral surface of the bracket; a rotatable ring which has a shape of rectangular ring and is rotatably mounted in the mounting hole of the rotatable bracket and which has a bent protrusion formed by bending at least a part of free end of the ring facing the mounting hole in one direction; a fixing body which is provided with adhesive means detachably attached to a flat surface of predetermined space and on which a pivotable bracket is pivotably mounted, the pivotable bracket having a receiving groove for receiving and supporting the bent protrusion of the rotatable ring; and an elastic member which is provided in the mounting hole and elastically supports at least a part of circumferential surface of the rotatable ring.

Herein, it is preferable that the receiving groove has a cross section of" L " shape.

### Effects of the invention

The multifunctional accessory for portable device of the present invention having the configuration and operation as described above has an advantage that it can be applied for various uses as a stand, a belt hanger, a finger holder etc. by simple configuration and easy operation.

### BRIEF DESCRIPTION OF THE DRAWINGS

**[List of Reference Numerals]**

| | | | |
|---|---|---|---|
| 1: | portable device | 3: | belt |
| 10: | piercing member | 12: | pressing plate |
| 14: | blade | 20: | main body |
| 22: | rubber pad | 24: | coupling groove member |
| 26: | coupling protrusion | 30: | fixing body |
| 32: | adhesive means | 40: | rotatable bracket |
| 42: | mounting hole | 50: | pivotable bracket |
| 52: | receiving groove | 60: | rotatable ring |
| 61: | bent protrusion | 62: | frictional member |
| 70: | protective case | 80: | elastic member |
| 90: | cover | | |

Figs. 1 and 2 are exemplary view illustrating uses of a multifunctional accessory for portable device according to an embodiment of the present invention;

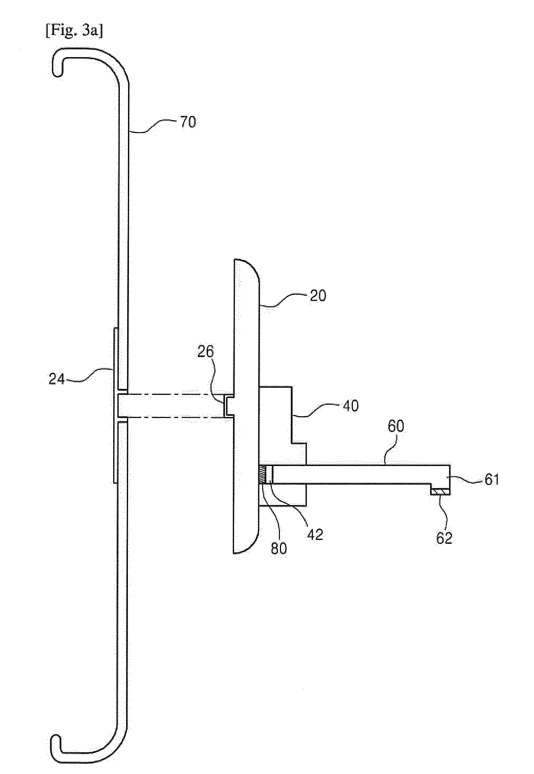

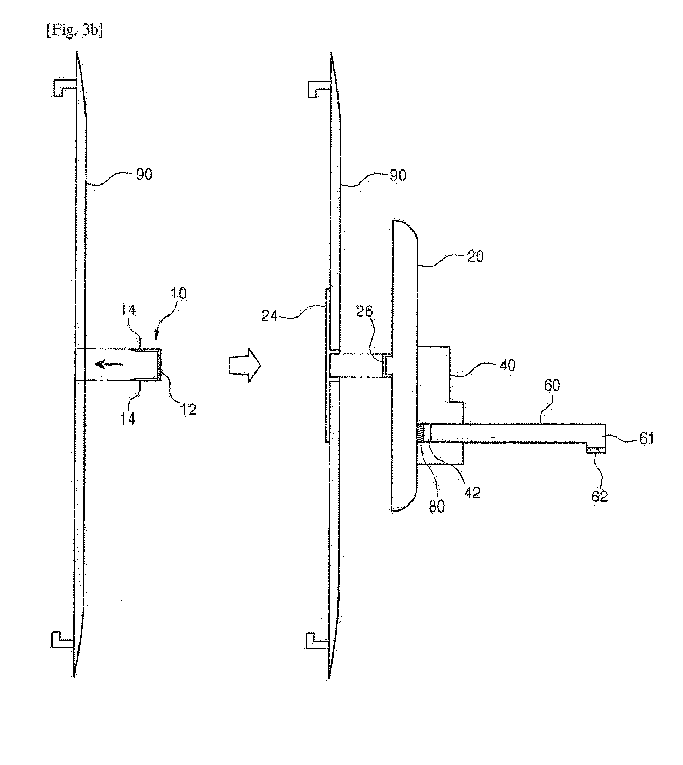

Figs. 3a and 3b are side view for describing embodiment examples of coupling means of the present invention;
Figs. 4a, 4b and 4c are side view and plane view for describing operation structure of the multifunctional accessory for portable device according to Figs. 1 and 2;
Fig. 5 is an exemplary view illustrating use of a multifunctional accessory for portable device according to another embodiment of the present invention; and
Fig. 6 is a side view for describing operation structure of the multifunctional accessory for portable device according to Fig. 5.

### BEST MODES FOR CARRYING OUT THE INVENTION

Hereinafter, a preferred embodiment of the present invention will be described in detail with reference to the attached drawings.

As illustrated in the attached drawings, a multifunctional accessory for portable device according to an embodiment of the present invention includes a main body (20) provided with coupling means which is detachably attached to the portable device; a rotatable bracket (40) which is provided on the main body (20) and can revolve; a rotatable ring (60) which is rotatably mounted on the rotatable bracket (40); and an elastic member (80) which elastically supports the rotatable ring (60).

Various coupling means may be selected for the main body (20), and an adhesive rubber pad (22) may be representatively selected. Such a rubber pad is provided on the whole of one surface of the main body (20) or on a part of the surface, and it is preferable that the rubber pad is provided on the whole of one surface so as to maximally increase adhesive force dependent on surface area.

Meanwhile, a protective case (70) may be further provided which wraps side and rear surfaces of the portable device. Such a protective case (70) has an opening part of predetermined shape which allows the coupling means to be detachably attached to the protective case. Herein, the coupling means includes a coupling groove member (24) which is inserted in the inside of the opening part; and a coupling protrusion (26) which is detachably coupled with the coupling groove member (24). The coupling groove member (24) and the coupling protrusion (26) may be detachably coupled with each other by various methods such as screw coupling, hook coupling, forced-fit coupling etc., and any method will do as long as it allows detachable coupling.

Furthermore, the accessory may further include a piercing member (10) which pierces one side of a rear cover (90) of the portable device to form an opening part of predetermined shape (the rear cover is a different concept from the protective case, is an outer cover of the portable device itself, and is also called a battery cover). The piercing cover (10) may consist of a circular pressing plate (12) and blade (14) formed along the circumference of the pressing plate (12). As such, the opening part is formed by positioning the blade (14) on the cover (90) at a position to be pierced and then pressing the pressing plate (12) or striking the plate with a hammer etc., which opening part allows detachable attaching of the coupling means. Herein, the coupling means includes the coupling groove member (24) which is inserted in the inside of the opening part; and the coupling protrusion (26) which is detachably coupled with the coupling groove member (24). The piecing member (10) as described above is a component in preparation for the case that the protective case (70) cannot be separately mounted on the portable device or is not necessary to mount. The piecing member is provided as a separate component from the coupling member or may be detachably provided on the main body (20) so that the piercing member is easy to carry.

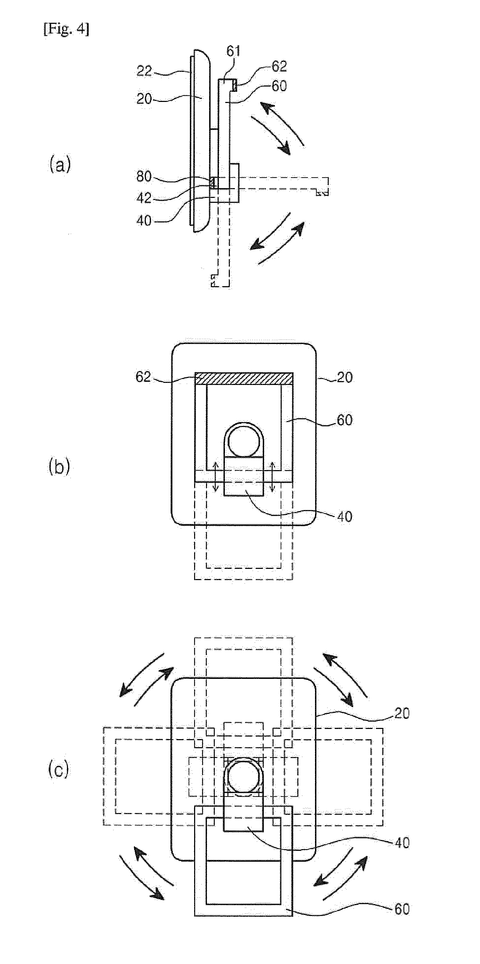

The rotatable bracket (40) is provided at a central portion of the other lateral surface of the main body (20) and revolves along a circumferential direction. Herein, lateral surface of the rotatable bracket (40) has a mounting hole (42) formed by penetrating a part of the lateral surface. Such a rotatable bracket (40) can revolve 360 degrees in the circumferential direction on the main body (20) as illustrated in Fig. 4(c), and thus the portable device (1) in contact with the main body (20) can be stood or fastened and fixed at various rotational angles.

The rotatable ring (60) has a shape of rectangular ring and is rotatably mounted in the mounting hole (42) of the rotatable bracket (40). As illustrated Figs 4(a) and (b), such a rotatable ring (60) vertically rotates on the rotatable bracket (40) away from and toward the bracket, and thus the portable device (1) in contact with the main body (20) can be stood or fastened and fixed at various inclinations.

Herein, a free end of the rotatable ring (60) has a bent protrusion formed by bending at least a part of the free end in one direction. Such a bent protrusion prevents slip when the portable device (1) is stood through the rotatable ring (60), and enhances securing capability when the portable device is fastened on a belt or bag. Furthermore, a frictional member (62) made of rubber material is fixed to an end portion of the bent protrusion of the rotatable ring (60) to prevent the slip.

The elastic member (80) is provided in the mounting hole (42) of the rotatable bracket (40) to elastically support at least a part of circumferential surface of the rotatable ring (60). Such an elastic member (80) prevents the slip of the rotatable ring (60) by elastically supporting the rotatable ring (60) in the mounting hole (42).

Meanwhile, cross section of the mounting hole (42) formed in the rotatable bracket (40) has a polygonal shape with at least four sides, and cross section of the rotatable ring (60) is formed to correspond to the polygonal shape of the mounting hole (42), and thus the rotatable ring (60) has a predetermined rotational angle. In the embodiment, the rotatable ring (60) has a rectangular cross section and thus has the rotational angle of 90 degrees. The rotational angle may be, of course, properly selected by those skilled in the art depending on use.

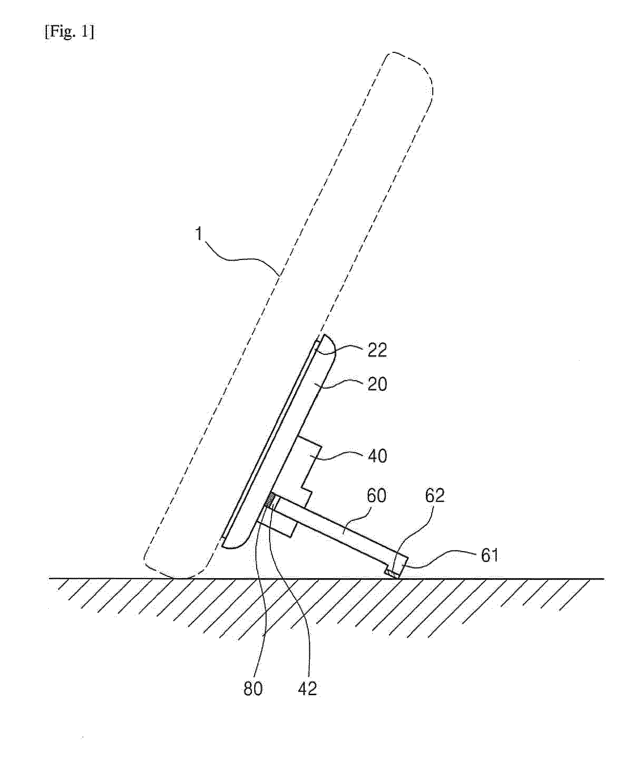

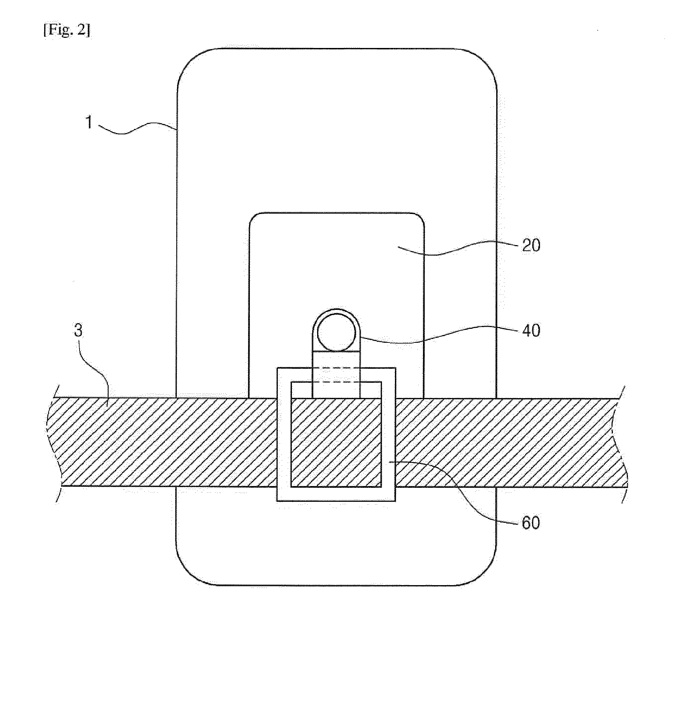

As illustrated in Figs. 1 and 2, the multifunctional accessory for portable device having the configuration and operation as described above may be applied as a stand or a belt hanger as necessary through simple operation and may be variously applied in addition.

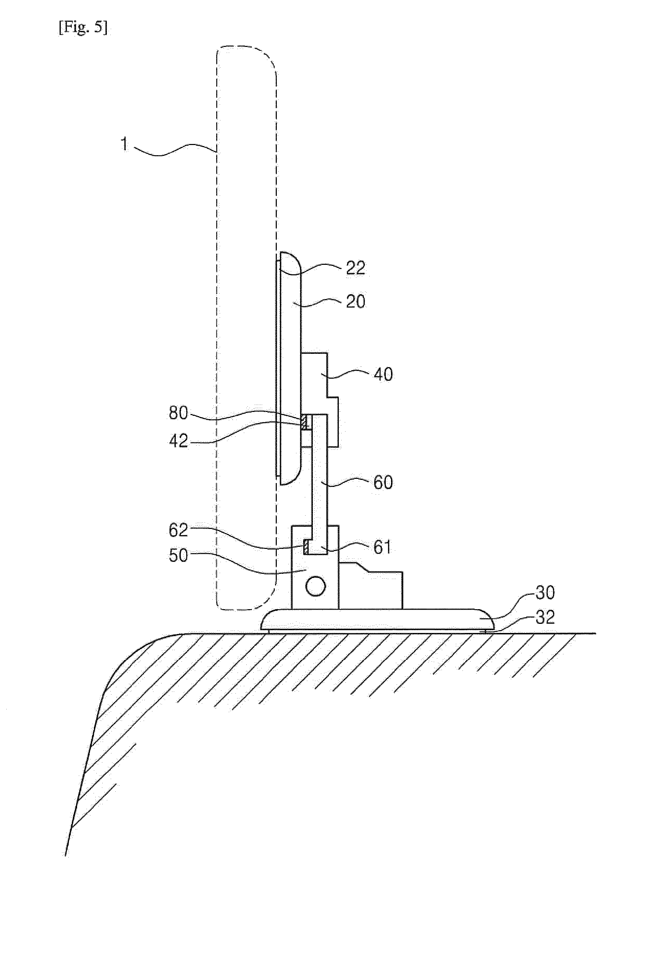

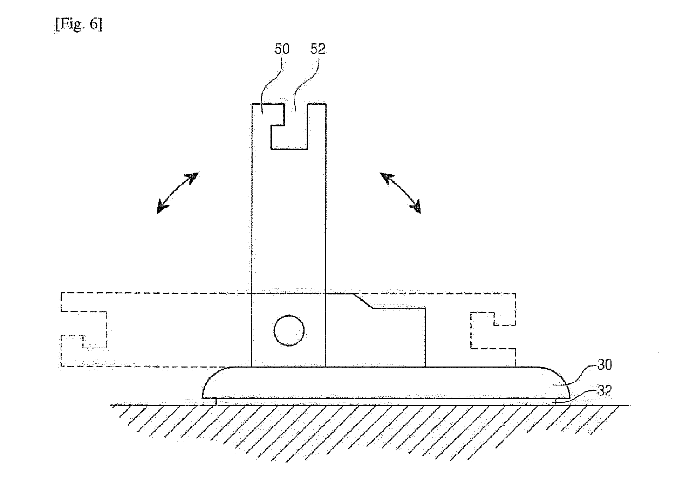

As illustrated in Figs. 5 and 6, the multifunctional accessory for portable device according to another embodiment of the present invention includes a plate-like fixing body (30) provided on its one lateral surface with adhesive means which is detachably attached to a surface of predetermined space; and a pivotable bracket (50) which is pivotably mounted on the fixing body (30) and which has a receiving groove (52) for receiving and supporting the bent protrusion of the rotatable ring (60) described in the previous embodiment. Herein, the receiving groove (52) preferably has a cross section of "└ " shape. The cross section with such a shape receives a part of the rotatable ring (60) connected with the bent protrusion as well as the bent protrusion of the rotatable ring (60) and thus can further enhance the supporting capability. In this case, the rotatable ring (60) is slidingly inserted in the receiving groove (52).

The multifunctional accessory for portable device configured as described above is suitable for use on a inclined surface or shaking place such as vehicle's dashboard as a position for standing the portable device.

The fixing body (30) and the pivotable bracket (50) have a structure identical or very similar to the main body (20) and the rotatable bracket (40) described in the previous embodiment; therefore, description thereof will be omitted.

According to the present invention described hitherto, the accessory may be applied for various uses as a stand, a belt hanger, a finger holder etc.. Furthermore, the portable can be stably used even on the inclined surface or shaking place such as vehicle's dashboard by using an auxiliary device.

In the above, features and technical advantages of the present invention have been widely described for better understanding of the scope of claims of the present invention described later. Those skilled in the art may make various modifications and alterations of the above-described embodiments within the scope of technical concepts of the present invention. Such various modifications and alterations are included in the scope of claims of the present invention described later as long as they are within the scope of technical concepts of the present invention.

## Claims

1. A multifunctional accessory for portable device which
is detachably attached to the portable device, comprising:
a main body provided with coupling means which is detachably attached to the portable device;
a rotatable bracket which is provided on a central portion of the other lateral surface of the main body and revolves along a circumferential direction and which has a mounting hole formed by penetrating a part of lateral surface of the bracket;
a rotatable ring which has a shape of rectangular ring and is rotatably mounted in the mounting hole of the rotatable bracket and which has a bent protrusion formed by bending at least a part of free end of the ring facing the mounting hole in one direction; and
an elastic member which is provided in the mounting hole and elastically supports at least a part of circumferential surface of the rotatable ring,
wherein cross section of the mounting hole formed in the rotatable bracket has a polygonal shape with at least four sides, cross section of the rotatable ring is formed to correspond to the polygonal shape of the mounting hole, and thus the rotatable ring has a predetermined rotational angle.

2. The multifunctional accessory for portable device
according to claim 1, wherein the coupling means consists of adhesive rubber pad.

3. A multifunctional accessory for portable device
which is detachably attached to the portable device, comprising:
a protective case which is formed to wrap side and rear surfaces of the portable device and which has an opening part of predetermined shape on one side of the case;
a main body provided with coupling means which comprises a coupling groove member inserted in the inside of the opening part of the protective case and a coupling protrusion detachably coupled with the coupling groove member;
a rotatable bracket which is provided on a central portion of the other lateral surface of the main body and revolves along a circumferential direction and which has a mounting hole formed by penetrating a part of lateral surface of the bracket;
a rotatable ring which has a shape of rectangular ring and is rotatably mounted in the mounting hole of the rotatable bracket and which has a bent protrusion formed by bending at least a part of free end of the ring facing the mounting hole in one direction; and
an elastic member which is provided in the mounting hole and elastically supports at least a part of circumferential surface of the rotatable ring.

4. A multifunctional accessory for portable device
which is detachably attached to the portable device, comprising:
a piercing member which pierces one side of a rear cover of the portable device to form an opening part of predetermined shape;
a main body provided with coupling means which comprises a coupling groove member inserted in the inside of the opening part of the cover and a coupling protrusion detachably coupled with the coupling groove member;
a rotatable bracket which is provided on a central portion of the other lateral surface of the main body and revolves along a circumferential direction and which has a mounting hole formed by penetrating a part of lateral surface of the bracket;
a rotatable ring which has a shape of rectangular ring and is rotatably mounted in the mounting hole of the rotatable bracket and which has a bent protrusion formed by bending at least a part of free end of the ring facing the mounting hole in one direction; and
an elastic member which is provided in the mounting hole and elastically supports at least a part of circumferential surface of the rotatable ring.

5. The multifunctional accessory for portable device
according to claim 1, wherein a frictional member made of rubber material is fixed to an end portion of the bent protrusion of the rotatable ring.

6. A multifunctional accessory for portable device which is detachably attached to the portable device, comprising:
a main body provided with coupling means which is detachably attached to the portable device;
a rotatable bracket which is provided on a central portion of the other lateral surface of the main body and revolves along a circumferential direction and which has a mounting hole formed by penetrating a part of lateral surface of the bracket;
a rotatable ring which has a shape of rectangular ring and is rotatably mounted in the mounting hole of the rotatable bracket and which has a bent protrusion formed by bending at least a part of free end of the ring facing the mounting hole in one direction;
a fixing body which is provided with adhesive means detachably attached to a flat surface of predetermined space and on which a pivotable bracket is pivotably mounted, the pivotable bracket having a receiving groove for receiving and supporting the bent protrusion of the rotatable ring; and
an elastic member which is provided in the mounting hole and elastically supports at least a part of circumferential surface of the rotatable ring.

7. The multifunctional accessory for portable device according to claim 6, wherein the receiving groove has a cross section of "└ " shape.
